# EUROPÄISCHE PATENTSCHRIFT

(11) **EP 3 329 751 B1**
(45) Veröffentlichungstag und Bekanntmachung des Hinweises auf die Patenterteilung: **11.08.2021**
(21) Anmeldenummer: 16729514.6
(22) Anmeldetag: 06.06.2016
(51) Int. Cl.: H05K 3/32, H05K 3/28, H05K 3/30, H05K 5/00

(54) **ELEKTRONIKMODUL MIT ÜBER SOCKELELEMENT FLEXIBEL PLATZIERBAREM BAUELEMENT UND VERFAHREN ZUM FERTIGEN DESSELBEN**
ELECTRONIC MODULE WITH A COMPONENT WHICH CAN BE FLEXIBLY PLACED BY MEANS OF A SOCKET ELEMENT, AND METHOD FOR PRODUCING SAME
MODULE ÉLECTRONIQUE COMPORTANT UN COMPOSANT POUVANT ÊTRE PLACÉ DE MANIÈRE FLEXIBLE SUR UN ÉLÉMENT SOCLE ET SON PROCÉDÉ DE FABRICATION

(30) Priorität: 29.07.2015 DE 102015214311
(43) Veröffentlichungstag der Anmeldung: 06.06.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/062802
(87) Internationale Veröffentlichungsnummer: WO 2017/016725

(56) Entgegenhaltungen:
- EP-A1- 1 424 708
- EP-A2- 0 855 851
- JP-A- H1 197 617

## Beschreibung

### Gebiet der Erfindung

Die vorliegende Erfindung betrifft ein Elektronikmodul, wie es beispielsweise als Getriebesteuermodul für ein Kraftfahrzeug eingesetzt werden kann. Ferner betrifft die Erfindung ein Verfahren zum Fertigen eines Elektronikmoduls.

### Stand der Technik

Elektronikmodule werden dazu eingesetzt, Schaltkreise aufzubauen, bei denen verschiedene elektrische und/oder elektronische Bauelemente miteinander verschaltet sind. Mithilfe derart verschalteter Bauelemente kann das Elektronikmodul bestimmte Funktionalitäten bereitstellen. Beispielsweise werden Elektronikmodule in Form von Getriebesteuermodulen dazu eingesetzt, Funktionen eines Getriebes in einem Kraftfahrzeug zu steuern. Neben einfachen Bauelementen wie zum Beispiel Widerständen, Kondensatoren, Induktivitäten etc. oder auch komplexeren Bauelementen wie zum Beispiel integrierten Schaltungen (IC - Integrated Circuit) oder anwendungs-spezifischen ICs (ASIC - application-specific integrated circuit) kann ein Elektronikmodul dabei auch Sensoren aufweisen, um beispielsweise Zustände innerhalb des zu steuernden Getriebes oder in einer Umgebung zu messen, und/oder Stecker aufweisen, um beispielsweise das Elektronikmodul oder Teile desselben mit externen Schaltkreisen elektrisch verbinden zu können.

Manche Bauelemente eines Elektronikmoduls müssen während dessen Betriebs von außen zugänglich sein bzw. Umgebungsbedingungen erfassen können. Beispielsweise sollten Sensoren an einem Elektronikmodul derart angebracht sein, dass zumindest ein sensierender Bereich eines Sensors mit zu erfassenden Umgebungsbedingungen wechselwirken kann. Stecker eines Elektronikmoduls sollten von außen her zugänglich sein.

Außerdem sollten manche Bauelemente wie insbesondere Sensoren und Stecker derart elektrisch mit den anderen Bauelementen bzw. einer diese anderen Bauelemente tragenden Leiterplatte elektrisch verbunden sein, dass auf sie im Betrieb des Elektronikmoduls wirkende erhebliche Kräfte langfristig nicht zu einer Beschädigung der elektrischen Verbindungen führen. Insbesondere herkömmliche Lötverbindungen können ein Risiko einer mechanischen Zerrüttung im Laufe der Lebensdauer des Elektronikmoduls bergen.

Die DE 10 2013 215 368 A1 beschreibt eine elektronische Einheit mit einer Leiterplatte, an der ein Sensor befestigt ist.

Aus der EP 1 424 708 A1 ist eine Schaltungsanordnung mit einer mindestens einen Kondensator aufweisenden elektronischen Schaltung bekannt, die eine Leiterplatte und eine den Kondensator sowie die Leiterplatte schützende Vergussmasse aufweist. Der Kondensator ist mit den Leiterbahnen elektrisch verbunden. Dabei ist der Kondensator in einem Schutzbecher angeordnet, wobei der Schutzbecher zwischen dem Kondensator und der Leiterplatte angeordnet ist. Die Vergussmasse umschließt den Schutzbecher teilweise derart, dass austretende Gase des Kondensators von einem Vergussmassenbereich in einen freien Bereich entweichen können.

Eine ähnliche Anordnung mit aus einem Kondensator und einer Leiterplatte ist aus der JP H11 97617 A bekannt.

Aus der EP 0 855 851 A2 ist eine Entladungslampeneinheit, die als Scheinwerfer eines Fahrzeugs verwendbar ist und die ein Gehause mit einem an demselben befestigten Entladungslampensockel aufweist bekannt. In Entladungssockel ist eine gedruckte Leiterplatte aufgenommen ist, wobei die gedruckte Leiterplatte mit einer Lampenzündungsschaltung und einer Transformatoranordnung in dem Gehäuse mit isolierendem Harz vergossen ist.

### Offenbarung der Erfindung

### Vorteile der Erfindung

Ausführungsformen der vorliegenden Erfindung können in vorteilhafter Weise ein Elektronikmodul bereitstellen, bei dem Bauelemente wie insbesondere Sensoren oder Stecker zuverlässig und langfristig stabil an einer Leiterplatte befestigt werden können. Insbesondere kann eine mechanische und elektrische Anbindung solcher Bauelemente an eine Leiterplatte in einer Weise erfolgen, in der sie mit industriell etablierten Fertigungsprozessen einfach umsetzbar ist und/oder bei der beispielsweise im Falle einer notwendigen Designänderung eine Positionierung eines anzubringenden Bauelements auf der Leiterplatte mit verhältnismäßig geringem Aufwand und innerhalb kurzer Zeit umgesetzt werden kann.

Gemäß einem ersten Aspekt der Erfindung wird ein Elektronikmodul beschrieben, das eine Leiterplatte, wenigstens ein erstes Bauelement, wenigstens ein Sockelelement, wenigstens ein zweites Bauelement und eine Schutzmasse aufweist. Das erste Bauelement ist an einer Oberfläche der Leiterplatte angeordnet und an dieser befestigt. Das Sockelelement weist eine erste Oberfläche und eine dieser entgegengesetzte zweite Oberfläche auf und ist mit seiner ersten Oberfläche an der Oberfläche der Leiterplatte anliegend angeordnet und an dieser befestigt. Das zweite Bauelement ist an dem Sockelelement befestigt und über dieses mit der Leiterplatte elektrisch verbunden. Die Schutzmasse ist an der Oberfläche der Leiterplatte angeordnet und kapselt das erste Bauelement ein. Das Sockelelement ist teilweise in die Schutzmasse derart eingebettet, dass seitliche Flanken des Sockelelements von der Schutzmasse bedeckt sind und die zweite Oberfläche des Sockelelements freiliegend aus der Schutzmasse herausragt. Das zweite Bauelement, das heißt beispielsweise der Sensor oder Stecker, weist elektrische Anschlüsse auf. Das Sockelelement weist elektrisch Anschlusselemente auf, welche mit elektrisch leitfähigen Strukturen an der Leiterplatte elektrisch verbunden sind. Die elektrischen Anschlüsse des zweiten Bauelements sind dabei mit den elektrischen Anschlusselementen des Sockelelements elektrisch verbunden. Insgesamt kann somit das zweite Bauelement über das Sockelelement und dessen Anschlusselemente mit elektrisch leitfähigen Strukturen der Leiterplatte elektrisch verbunden sein. Eine Anschlussstelle, an der die elektrischen Anschlüsse mit den elektrischen Anschlusselementen verbunden sind, ist verkapselt. Eine solche Verkapselung kann dazu dienen, die Anschlussstelle gegenüber einem Einwirken von äußeren Einflüssen, insbesondere gegenüber einem Einwirken von Chemikalien wie zum Beispiel Getriebeflüssigkeit, zu schützen. Die Verkapselung kann hermetisch dicht ausgeführt sein, so dass keinerlei Chemikalien an die Anschlussstelle gelangen können. Die Verkapselung kann beispielsweise einen Schutzlack oder Harz umfassen, welche in flüssigem Zustand über die Anschlussstelle gegeben, dort gegebenenfalls verteilt und abschließend ausgehärtet werden. Alternativ kann die Verkapselung beispielsweise mithilfe einer abdichtenden Schutzkappe erfolgen.

Gemäß einem zweiten Aspekt der Erfindung wird ein Verfahren zum Fertigen eines Elektronikmoduls beschrieben, das die folgenden Schritte aufweist: Zunächst wird eine Leiterplatte bereitgestellt. An einer Oberfläche der Leiterplatte wird wenigstens ein erstes Bauelement angeordnet. Ferner wird an der Oberfläche der Leiterplatte wenigstens ein Sockelelement mit seiner ersten Oberfläche angeordnet. Ein zweites Bauelement wird an dem Sockelelement angeordnet. Das erste Bauelement wird in eine Schutzmasse derart eingebettet, dass das erste Bauelemente in der Schutzmasse einkapselt ist. Das Verfahren zeichnet sich dadurch aus, dass mit dem Einbetten des ersten Bauelements auch das Sockelelement teilweise in die Schutzmasse derart eingebettet wird, dass seitliche Flanken des Sockelelements von der Schutzmasse bedeckt werden und die zweite Oberfläche des Sockelelements freiliegend aus der Schutzmasse herausragt. Das zweite Bauelement wird dabei vorzugsweise erst nach dem Aufbringen und gegebenenfalls Vernetzen der Schutzmasse an dem Sockelelement angeordnet. Das zweite Bauelement weist elektrische Anschlüsse auf und das Sockelelement weist elektrische Anschlusselemente auf, welche mit elektrisch leitfähigen Strukturen an der Leiterplatte elektrisch verbunden werden, wobei die elektrischen Anschlüsse mit den elektrischen Anschlusselementen elektrisch verbunden werden und eine Anschlussstelle, an der die elektrischen Anschlüsse mit den elektrischen Anschlusselementen verbunden werden, verkapselt wird.

Ideen zu Ausführungsformen der vorliegenden Erfindung können unter anderem als auf den nachfolgend beschriebenen Gedanken und Erkenntnissen beruhend angesehen werden.

Wie weiter unten anhand eines Beispiels beschrieben, werden in herkömmlichen Elektronikmodulen Sensoren und/oder Stecker häufig mithilfe von Trägerplatten an einer Leiterplatte befestigt. Die Trägerplatten, welche gegebenenfalls relativ hohe von dem Sensor bzw. Stecker ausgeübte Kräfte aufnehmen sollen und gleichzeitig den Sensor bzw. Stecker zuverlässig mit elektrischen Verbindungen zu anderen Bauelementen, welche beispielsweise auf einer Leiterplatte vorgesehen sind, verbinden sollen, können innerhalb des Elektronikmoduls beispielsweise durch Schrauben oder Nietverbindungen zuverlässig mechanisch befestigt sein. Aus einem Sensor bzw. Stecker ragende Pins können in Leiterplatten oder Flexfolien stecken und mit diesen insbesondere durch Durchsteck-Lötkontakte (THT-Kontakte) elektrisch verbunden sein oder an weiterleitende Stanzgitter geschweißt oder gelötet sein. Diese Leiterplatten, Flexfolien oder Stanzgitter können den Sensor bzw. Stecker mit beispielsweise einem zentralen Getriebesteuergerät (iTCU) oder einem Getriebestecker verbinden.

Allerdings sind Positionen der Sensoren bzw. Stecker hierbei heute im Regelfall fix vorgegeben, was insbesondere aus einer fixen Gestalt der Trägerplatten, Stanzgitter und Flexfolien resultiert. Soll beispielsweise ein Design eines Elektronikmoduls geändert werden, kann es erforderlich sein, Sensoren bzw. Stecker an Leiterplatten neu zu positionieren. Dies kann jedoch bisher häufig an zum Befestigen der zugehörigen Trägerplatte eingesetzten Befestigungsschrauben oder Nieten scheitern, die beispielsweise Flächen und Freiraum auf der Leiterplatte und der Trägerplatte benötigen.

Es wurde daher nach einer Lösung gesucht, ein Elektronikmodul, insbesondere für einen Einsatz als Getriebesteuermodul, derart auszubilden und zu fertigen, dass zum Beispiel für einen Fall, dass eine Designänderung oder Variantenbildung des Elektronikmoduls vorgenommen werden soll, eine Position von bestimmten Bauelementen, insbesondere Sensoren oder Steckern, auf einer Leiterplatte des Elektronikmoduls in einfacher Weise angepasst werden kann.

Ausführungsformen des hierin vorgestellten Elektronikmoduls bzw. des hierin beschriebenen Fertigungsverfahrens können einen solchen Bedarf erfüllen. Hierbei können die Sensoren bzw. Stecker vorteilhafterweise erst nach Fertigstellung einer Elektronik montiert und kontaktiert werden und hierbei insbesondere sehr stabil auf dem Modul fixiert werden. Außerdem kann ein optimaler Schutz gegen Späne und/oder chemische Angriffe beispielsweise auf Verbindungsstellen ermöglicht werden.

Es wird vorgeschlagen, ein zweites Bauelement wie zum Beispiel einen Sensor, einen Stecker oder eine weitere Baugruppe mit Anschlusskontakten an einer Leiterplatte über ein Sockelelement zu befestigen, wobei das Sockelelement jedoch nicht notwendigerweise ähnlich wie die oben beschriebenen Trägerplatten über Schraub- oder Nietverbindungen an der Leiterplatte gehalten sind. Stattdessen soll das Sockelelement in eine Schutzmasse mit eingebettet werden, welche an der Oberfläche der Leiterplatte angeordnet ist und dort andere Bauelemente verkapseln soll. Während die anderen Bauelemente jedoch vollständig verkapselt sein sollen, das heißt, in die Schutzmasse derart integriert und von dieser vorzugsweise vollständig bedeckt sein sollen, dass sie gegen äußere Einflüsse wie beispielsweise von außen einwirkende Chemikalien geschützt sind, soll das Sockelelement lediglich derart in die Schutzmasse eingebettet sein, dass seitliche Flanken des Sockelelements zwar von der Schutzmasse bedeckt sind, das Sockelelement jedoch nicht vollständig in die Schutzmasse eingekapselt ist, sondern seine zweite Oberfläche freiliegend aus der Schutzmasse herausragt. Mit anderen Worten soll die Schutzmasse das Sockelelement zwar seitlich umgeben und durch mechanische Anlage an die seitlichen Flanken des Sockelelements das Sockelelement auf der Leiterplatte stabilisieren, die Schutzmasse soll jedoch nicht das Sockelelemenf komplett überdecken, so dass zumindest die zweite Oberfläche des Sockelelements frei von Schutzmasse bleibt und somit von außen her zugänglich bleibt.

Die Schutzmasse kann beispielsweise ein Lack, eine Moldmasse, eine Vergussmasse oder Harz sein, insbesondere aus einem duroplastischen Material. Beispielsweise kann die Schutzmasse ein Lack oder ein Harz auf Epoxidbasis oder eine Masse auf Basis eines duroplastischen Polyesters sein, wie sie häufig zum Vergießen und Kapseln von elektrischen Bauelementen eingesetzt wird. Solche Lacke, Harze, Moldmassen oder Vergussmassen können während des Verarbeitens fließfähig sein und nachfolgend thermisch oder durch Strahlungsenergie ausgehärtet werden.

Insbesondere kann die Schutzmasse zum Einbetten des Sockelelements und des ersten Bauelements mithilfe eines Dispensvorgangs aufgebracht werden. Bei einem solchen Dispensvorgang wird ein fließfähig zu verarbeitender Stoff auf eine Oberfläche, das heißt im vorliegenden Fall auf die Oberfläche der Leiterplatte, aufgebracht, d.h. beispielsweise aufgetropft, und gegebenenfalls in gewünschten Bereichen verteilt, um dann abschließend ausgehärtet zu werden. Ein Vorteil eines solchen Dispensvorgangs ist unter anderem, dass keine aufwendigen Werkzeuge benötigt werden.

Prinzipiell wäre auch ein Aufbringen und Ausformen der Schutzmasse mithilfe von Spritzguss und Molden vorstellbar. Dies würde jedoch einen deutlich höheren Aufwand, beispielsweise für komplexe Spritzguss- bzw. Mold-Werkzeuge, erfordern und auch bei einer gewünschten Änderung von Positionen der Bauteile bzw. des Sockelelements auf der Leiterplatte zu einem zusätzlichen Aufwand führen.

Das Sockelelement kann ein an der Leiterplatte oberflächenmontiertes Bauteil sein. Mit anderen Worten kann das Sockelelement derart ausgebildet sein, dass es in herkömmlicher SMD-Technologie (Surface Mounted Device) an der Leiterplatte angebracht und mit dieser elektrisch verbunden werden kann. Ein solches oberflächenmontiertes Anbringen kann eine zuverlässige mechanische wie auch elektrische Verbindung zwischen dem Sockelelement und der Leiterplatte ermöglichen. Außerdem kann beispielsweise vermieden werden, dass Durchsteck-Lötkontakte an einer gegenüberliegenden Seite der Leiterplatte über deren Oberfläche hinausragen und gegebenenfalls geschützt werden müssten.

Die Anschlusselemente des Sockelelements können dabei vorteilhafterweise durch SMD-Technologie oder in anderer Weise mit entsprechenden Anschlussflächen an der Leiterplatte verbunden, insbesondere verlötet, sein. Teile der Anschlusselemente können beispielsweise aus einem einen Körper des Sockelelements bildenden Kunststoffblock herausgeführt sein, so dass sie dort mit den Anschlüssen des zweiten Bauelements verbunden werden können. Die Anschlusselemente können metallisch sein, beispielsweise in Form von gestanzten Leitblechen. Ferner können sie in einem den Block des Sensorelements bildenden Kunststoff eingebettet sein. Der Block kann beispielsweise quaderförmig sein.

Vorteilhafterweise können die elektrischen Anschlüsse des zweiten Bauelements mit den elektrischen Anschlusselementen des Sockelelements verschweißt werden. Hierfür kann beispielsweise Laserschweißen oder Widerstandsschweißen eingesetzt werden. Eine Schweißverbindung zwischen den elektrischen Anschlüssen des zweiten Bauelements und den elektrischen Anschlusselementen des Sockelelements kann eine sehr zuverlässige elektrische Verbindung sowie eine langfristig belastbare mechanische Verbindung zwischen diesen Komponenten ermöglichen. Insbesondere Laserschweißen ermöglicht eine flexible, an räumliche Gegebenheiten anpassbare Weise, um Verschweißungen zu realisieren.

Alternativ können die genannten Komponenten auch durch andere Verbindungsverfahren wie beispielsweise Löten, insbesondere Bügellöten oder Laserlöten, miteinander verbunden werden.

Das Sockelelement und das zweite elektrische Bauelement können aneinander irreversibel, insbesondere durch Kleben, Warmverstemmen und/oder Pressverbinden, mechanisch befestigt werden. Eine solche irreversible Befestigung kann bedingen, dass das Sockelelement und das zweite elektrische Bauelement nicht mehr schädigungsfrei voneinander getrennt werden können. Beispielsweise kann das zweite Bauelement mit dem Sockelelement verbunden werden, indem eine Kontaktfläche zwischen diesen beiden Elementen mit einem Klebemittel versehen wird, welches nachfolgend aushärtet. Alternativ können Teilbereiche der beiden oder eines der beiden Elemente temporär erwärmt werden, um die beiden Elemente dann warm zu verstemmen, so dass sie nach einem Abkühlen fest miteinander verbunden sind. Als weitere Alternative können Teile des Sockelelements derart mit Teilen des zweiten Bauelements verpresst werden, dass sich eine irreversible Verbindung zwischen beiden ergibt. Eine derartige irreversible Befestigung kann langfristig stabil sein, so dass das zweite Bauelement auch über lange Zeiträume hin und trotz darauf wirkender erheblicher Kräfte zuverlässig an der Leiterplatte gehalten sein kann.

Gemäß einer Ausführungsform weisen das erste Bauelement und das Sockelelement derartige Baugrößen auf, dass sie mittels eines selben Bestückungsautomaten auf die Leiterplatte bestückt werden können. Mit anderen Worten soll das Sockelelement nicht wesentlich größer sein als die ansonsten auf der Leiterplatte anzuordnenden ersten Bauelemente, so dass es in gleicher Weise wie diese Bauelemente mit einem Bestückungsautomaten auf die Leiterplatte bestückt werden kann. Der Bestückungsautomat kann dabei beispielsweise ein Bauelement oder, alternativ, ein Sockelelement greifen und an geeigneter Position auf die Leiterplatte setzen und es an dieser befestigen, beispielsweise unter Verwendung der SMD-Technologie. Das Sockelelement soll beispielsweise nicht mehr als 100%, vorzugsweise nicht mehr als 50% und stärker bevorzugt nicht mehr als 20%, größer sein als eines der auf der Leiterplatte anzuordnenden ersten Bauelemente, insbesondere als das größte der auf der Leiterplatte anzuordnenden ersten Bauelemente. Beispielsweise soll das Sockelelement keine als Grundfläche dienende erste Oberfläche aufweisen, die größer als beispielsweise 20cm² ist. Zum Beispiel sollte das Sockelelement eine Grundfläche von typischerweise weniger als 2x2cm² aufweisen. Ein Sockel für einen Drehzahlsensor hat beispielsweise eine übliche Grundfläche von 15×15mm². Es kann aber auch ein Sockel für eine lange Kontaktleiste aufgesetzt werden, um daran z. B. 20 Leitbleche für einen Stecker zu befestigen, wobei ein solcher Sockel beispielsweise eine Grundfläche von 10×150mm² aufweist. Während eines Fertigungsvorgangs können somit sowohl die ersten Bauelemente als auch das Sockelelement bzw. mehrere Sockelelemente in einem gemeinsamen Bestückungsvorgang und mit einem gemeinsamen Bestückungsautomaten auf die Leiterplatte bestückt werden.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt ein herkömmliches Elektronikmodul.
Fig. 2 zeigt ein Elektronikmodul gemäß einer Ausführungsform der vorliegenden Erfindung.
Fig. 3 zeigt eine vergrößerte Ansicht auf Teile des Elektronikmoduls aus Fig. 2.
Fig. 4 zeigt ein Elektronikmodul gemäß einer weiteren Ausführungsform der vorliegenden Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

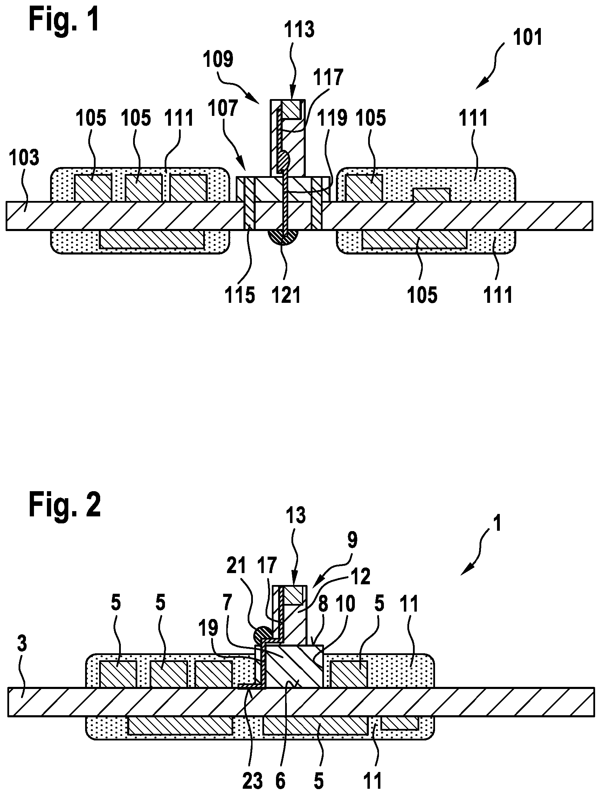

Fig. 1 zeigt ein Beispiel eines herkömmlichen Elektronikmoduls 101, wie es zum Beispiel als Getriebesteuermodul eingesetzt werden kann. Auf einer Leiterplatte 103 sind mehrere elektrische und elektronische Bauelemente 105 sowohl an einer Vorderseite als auch an einer Rückseite vorgesehen. Ferner ist ein zweiter Typus von Bauelement in Form eines Sensors 109 vorgesehen. Der Sensor 109 ist an der Leiterplatte 103 über einen Flansch 107 gehalten. Der Flansch 107 ist mittels Schrauben oder Nieten 115 an der Leiterplatte 103 mechanisch fixiert.

Der Flansch 107 weist ferner mindestens ein Leitblech 119 auf, das in einer Durchgangsbohrung der Leiterplatte 103 aufgenommen ist und somit von der Vorderseite der Leiterplatte 103, an der der Flansch 107 angeordnet ist, bis hin zur Rückseite der Leiterplatte 103 reicht und in Form eines Durchsteck-Lötkontakts elektrisch mit leitenden Strukturen auf der Leiterplatte 103 verbunden ist. Das Leitblech 119 ist in eine passende Öffnung in einem Sensordom des Sensors 109 eingebracht und mit dortigen Metallkontakten 117 elektrisch verbunden, beispielsweise durch eine Lötverbindung. Ein Sensor-IC 113 ist an einem obersten Ende des Sensors 109 angeordnet und bildet dessen sensierendes Element. Der Sensor-IC 113 ist somit über die Kontakte 117 und Leitbleche 119 mit der Leiterplatte 103 elektrisch verbunden. Die Bauelemente 105 sind mithilfe einer Schutzmasse 111 verkapselt. Die Schutzmasse bedeckt jedoch in diesem Fall nicht den Flansch 107, sondern endet neben diesem. An einer Rückseite der Leiterplatte 103 schützt ein Lackpunkt 121 einen dort überstehenden Teil des Durchsteck-Lötkontakts.

Bei einem solchen Elektronikmodul 101 ist die Position des Sensors 109 allenfalls mit viel Aufwand zu verändern. Eine Designänderung oder Neuauslegung der Leiterplatte 103 würde unter anderem erfordern, dass Positionen der Befestigungsschrauben bzw. -nieten 115 sowohl an der Leiterplatte 113 als auch gegebenenfalls am Flansch 107 geändert werden müssten. Auch hierfür vorgesehener Freiraum auf der Leiterplatte und/oder der Trägerplatte müsste angepasst werden. Erfahrungsgemäß sind für derart weitreichende Designänderungen insbesondere bei komplexeren Elektronikmodulen, bei denen unter anderem eventuell Stanzgittermodule, Module aus Kunststoffträgerplatten und/oder Flexfolien eingesetzt werden, lange Vorlaufzeiten von bis zu 12 Monaten für deren Umsetzung notwendig.

Außerdem werden üblicherweise bei der Fertigung herkömmlicher Elektronikmodule, wie sie beispielhaft mit Bezug auf Fig. 1 beschrieben sind, die kompletten Sensoren 109 bereits mit zugehöriger Elektronik bestückt und verbunden, obwohl diese keine Bauelemente sind, die in Bestückungsautomaten passen. Ergänzend oder alternativ müssen auf der Leiterplatte 103 typischerweise Freiflächen im Verguss- bzw. Lackierprozess zum Ausbilden der Schutzmasse 111 ausgespart werden, in denen später die Sensoren 109 platziert, befestigt und kontaktiert werden können. Dies ist aufwendig und benötigt erheblichen Bauraum.

Ferner werden bei dem in Fig. 1 dargestellten Elektronikmodul 101 elektrische Kontaktierungsverfahren eingesetzt wie zum Beispiel Pin-in-Hole-Lötungen oder THT-Lötungen (Through-Hole Technology) in einem Selektivlötprozess. Diese können mit sich bringen, dass Lötpins aus der Leiterplatte 103 herausstehen und gegen Kurzschlüsse oder Ähnliches extra geschützt werden müssen, gegebenenfalls zusätzlich zu einem Schutz an der Oberseite der Leiterplatte 103.

Es wird daher ein Elektronikmodul 1 vorgeschlagen, wie es nachfolgend beispielhaft anhand der in den Fig. 2, 3 und 4 dargestellten Ausführungsformen beschrieben werden soll.

Das Elektronikmodul 1 weist eine Leiterplatte 3 auf, an der wenigstens ein, vorzugsweise mehrere erste Bauelemente 5 vorgesehen sind, gegebenenfalls an sowohl der vorderen als auch der hinteren Oberfläche. Die elektrischen oder elektronischen Bauelemente 5 können in beliebiger Weise, vorzugsweise in einer oberflächenmontierten (SMD) Weise auf die Leiterplatte 3 bestückt sein.

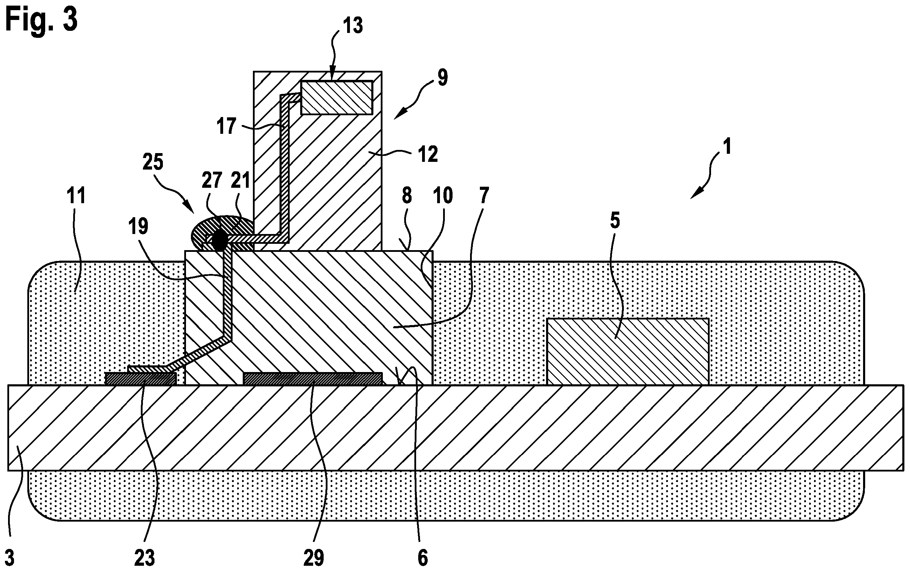

Auf der Oberfläche der Leiterplatte 3 ist ferner ein Sockelelement 7 vorgesehen, welches eine erste Oberfläche 6 und eine dieser entgegengesetzt angeordnete zweite Oberfläche 8 aufweist. Die erste und die zweite Oberfläche 6, 8 können parallel zueinander sein, sie können aber auch in einer anderen Anordnung zueinander stehen. D.h. beispielsweise kann die zweite Oberfläche 8 auch schräg zu der ersten Oberfläche 6 stehen. Insbesondere kann die zweite Oberfläche 8 plan oder gekrümmt sein. Mit seiner ersten Oberfläche 6 liegt das Sockelelement 7 an der Oberfläche der Leiterplatte 3 an. Gegebenenfalls kann das Sockelelement 7 über eine Lötfläche 29 (siehe Fig. 3) an der Oberfläche der Leiterplatte 3 angelötet sein, vorzugsweise in oberflächenmontierter Weise. Das Sockelelement 7 kann hierbei einen beispielsweise quaderförmigen Körper aus einem nicht leitenden Material wie beispielsweise einem Duroplast wie zum Beispiel Epoxidharz aufweisen. In diesen Körper eingelassen sind elektrische Anschlusselemente 19 beispielsweise in Form von gestanzten Blechen. Enden dieser Anschlusselemente 19 ragen über den Körper des Sockelelements 7 nach außen ab und können somit nach außen kontaktiert werden. Beispielsweise kann ein unteres Ende eines Anschlusselements 19 an ein Lötpad 23 an der Oberfläche der Leiterplatte 3 angrenzen und mit diesem verlötet sein. Ein oberes Ende eines Anschlusselements 19 kann nach oben über den Körper des Sockelelements 7 und damit über die zweite Oberfläche 8 des Sockelelements 7 hinaus abragen.

Das Sockelelement 7 ist in diesem Fall ausreichend klein und in einer Weise ausgestaltet, dass es ähnlich wie die ersten elektrischen Bauelemente 5 mithilfe eines Bestückungsautomaten auf die Leiterplatte 3 bestückt werden kann. Hierbei kann der Bestückungsautomat das Sockelelement 7 an geeigneter Position auf der Leiterplatte 3 positionieren und gegebenenfalls mit dieser verlöten, um elektrische und/oder mechanische Verbindungen herzustellen.

Nachdem sowohl die elektrischen ersten Bauelemente 5 als auch das Sockelelement 7 auf die Leiterplatte 3 bestückt worden sind, wird eine Schutzmasse 11 beispielsweise in Form eines Lacks oder eines Harzes auf eine oder beiden Oberflächen der Leiterplatte 3 aufgebracht. Beispielsweise kann die Schutzmasse 11 im Rahmen eines Dispensvorgangs aufgebracht werden, bei dem die Schutzmasse im fließfähigen Zustand beispielsweise auf die zu schützenden Oberflächen der Leiterplatte 3 aufgetropft und dabei oder danach über gewünschte Regionen verteilt wird. Die Schutzmasse 11 überdeckt dabei die ersten Bauelemente 5 vollständig, so dass diese gekapselt und somit geschützt gegenüber Umwelteinflüssen und zwischen der Schutzmasse 11 und der Leiterplatte 3 aufgenommen sind. Gleichzeitig umfließt die flüssige Schutzmasse 11 auch das Sockelelement 7. Allerdings ist das Sockelelement 7 mit einer größeren Höhe ausgebildet als die Bauelemente 5, so dass die Schutzmasse 11 zwar seitliche Flanken 10 des Sockelelements 7 umgibt und somit das Sockelelement 7 in sich einbettet, jedoch nicht die zweite obere Oberfläche 8 des Sockelelements 7 überdeckt. An seiner oberen zweiten Oberfläche 8 ragt das Sockelelement 7 somit über die Schutzmasse 11 nach oben ab und liegt somit unbedeckt frei. In einem nachfolgenden Schritt kann die Schutzmasse 11 beispielsweise thermisch oder durch Strahlungsenergie ausgehärtet werden. Das Sockelelement 7 ist anschließend in die ausgehärtete Schutzmasse 11 eingebettet und über seine Grundfläche und seine seitlichen Flanken mechanisch sehr stabil befestigt. Insbesondere die Verbindung zwischen dem Sockelelement 7 und der Leiterplatte 3, das heißt beispielsweise die elektrische Verbindung zwischen dem Anschlusselement 19 und dem Lötpad 23 sowie die mechanische Verbindung über die oberflächenmontierte Verlötung 29 an der Unterseite des Sockelelements 7 sind durch die Schutzmasse 11 vollständig geschützt.

In einem anschließenden Fertigungsschritt, das heißt beispielsweise in einer nachfolgenden Montagelinie, wird die auf die Weise vorbereitete Elektronik mit der bestückten Leiterplatte 3 mit zweiten Bauelementen 9 wie beispielsweise einem Sensor oder einem Stecker bestückt. Das zweite Bauelement 9 kann dabei einen beispielsweise quaderförmigen oder zylindrischen Körper 12 aufweisen, der zum Beispiel aus einer Kunststoffmasse, insbesondere einer Duroplastmasse, besteht. In diesen Körper 12 können elektrische oder elektronische Bauteile wie beispielsweise eine Sensorzelle 13 zum Beispiel in Form eines IC oder eines ASIC eingebettet sein. Diese Bauteile können beispielsweise fest in den Duroplast des Körpers 12 eingemoldet oder gespritzt sein. Original-Anschlussbeine, welche elektrische Anschlüsse 17 des zweiten Bauelements 9 bilden können, können, im Idealfall ohne weitere Verlängerung, unten oder am Rand des Körpers 12 herausragen.

Wie in Fig. 3 gut erkennbar, können die über den Sensorkörper 12 abragenden Teile der Anschlüsse 17 nachfolgend mit dem über den Körper des Sockelelements 7 abragenden Teilen der Anschlusselemente 19 elektrisch verbunden werden, beispielsweise indem diese an einer Anschlussstelle 25 unter Bildung einer als elektrischer Kontakt dienenden Schweißstelle 27 verschweißt werden. Eine solche Verschweißung ermöglicht eine langfristig zuverlässige elektrische Anbindung des zweiten Bauelements 9 über das Sockelelement 7 an elektrisch leitfähige Strukturen der Leiterplatte 3.

Nachfolgend wird die Anschlussstelle 25 verkapselt, um sie beispielsweise gegen Umwelteinflüsse wie einen Angriff von Chemikalien, insbesondere Getriebeflüssigkeit, zu schützen. Hierzu kann beispielsweise eine weitere Schutzmasse 21 in Form eines Lacks oder eines Harzes über die Anschlussstelle 25 dispensed und anschließend ausgehärtet werden, wie dies in der Ausführungsform aus Fig. 3 dargestellt ist.

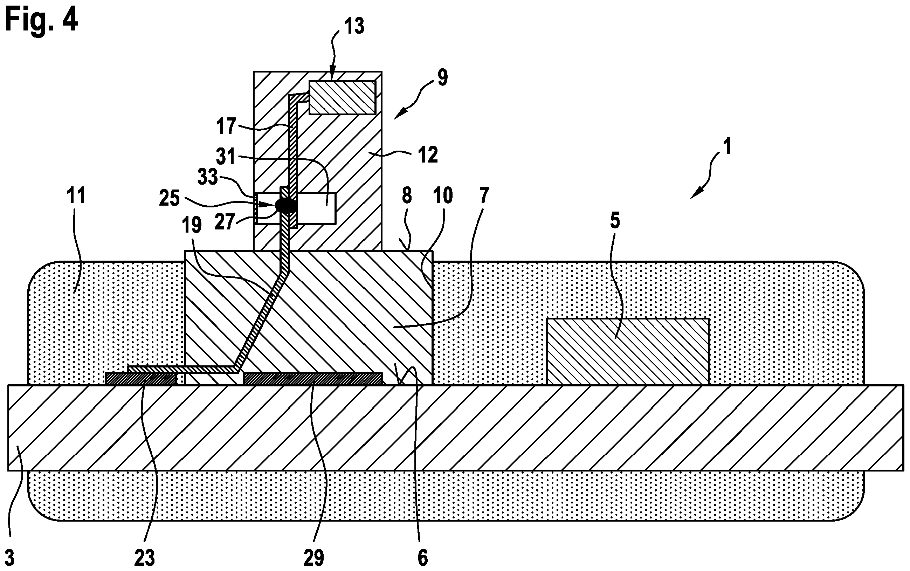

Alternativ kann, wie in Fig. 4 dargestellt, ein nach oben abragendes Ende eines Anschlusselements 19 des Sockelelements 7 in eine geeignet dimensionierte Ausnehmung in dem Sensorkörper 12 eingeführt werden. In dem Sensorkörper 12 ist ferner eine zunächst nach außen offene Aussparung 31 vorgesehen, beispielsweise in Form eines Sacklochs. Im Bereich dieser Aussparung 31 können das Ende des Anschlusselements 19 und ein Ende eines Anschlusses 17 des zweiten Bauelements 9 einander überlappen und miteinander an einer Anschlussstelle 25 durch eine Verschweißung 27 verbunden werden. Abschließend kann die Aussparung 31 beispielsweise mithilfe einer Kappe 33 geschlossen und somit verkapselt werden.

Um das zweite Bauelement 9 mit dem Sockelelement 7 auch mechanisch fest zu verbinden, können diese beispielsweise miteinander verklebt, warmverstemmt, über eine Pressverbindung aneinander gehalten oder in anderer Weise mechanisch miteinander verbunden werden.

Ausführungsformen des hierin beschriebenen Elektronikmoduls und des Verfahrens zum Fertigen eines solchen Elektronikmoduls 1 können mehrere Vorteile gewähren. Beispielsweise können Designänderungen an der Leiterplatte 3 einfach und schnell, beispielsweise innerhalb von lediglich 2 Monaten, umgesetzt werden. Zweite Bauelemente 9 in Form von beispielsweise Sensoren oder Steckern können sehr stabil an dem Modul 1 bzw. an dessen Leiterplatte 3 fixiert werden. Außerdem können alle kritischen Stellen, insbesondere Anschlussstellen 25, optimal gegenüber beispielsweise Spänen oder chemischem Angriff geschützt werden. Es können Standardsensordome beispielsweise aus einem Baukasten verwendet werden, wobei solche standardisierten Bauteile über standardisierte Schnittstellen verfügen können. Eine Varianz der zweiten Bauteile 9, insbesondere von Sensoren, kann in dem Sockelelement 7 liegen, beispielsweise durch unterschiedlich hohe Sockelelemente 7 oder schräge Flächen an dem Sockelelement 7.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronikmodul (1), aufweisend:
eine Leiterplatte (3);
ein erstes Bauelement (5), welches an einer Oberfläche der Leiterplatte (3) angeordnet und an dieser befestigt ist;
ein Sockelelement (7), welches eine erste Oberfläche (6) und eine dieser entgegengesetzte zweite Oberfläche (8) aufweist und welches mit seiner ersten Oberfläche (6) an der Oberfläche der Leiterplatte (3) anliegend angeordnet und an dieser befestigt ist;
ein zweites Bauelement (9), welches an dem Sockelelement (7) befestigt ist und über dieses mit der Leiterplatte (3) elektrisch verbunden ist;
eine Schutzmasse (11) zum Schutz vor Umwelteinflüssen, welche an der Oberfläche der Leiterplatte (3) angeordnet ist und das erste Bauelemente (5) einkapselt; wobei das Sockelelement (7) teilweise in die Schutzmasse (11) derart eingebettet ist, dass seitliche Flanken (10) des Sockelelements (7) von der Schutzmasse (11) bedeckt sind und die zweite Oberfläche (8) des Sockelelements (7) freiliegend aus der Schutzmasse (11) heraus ragt,
**dadurch gekennzeichnet, dass** das zweite Bauelement (9) elektrische Anschlüsse (17) aufweist und das Sockelelement (7) elektrische Anschlusselemente (19) aufweist, welche mit elektrisch leitfähigen Strukturen an der Leiterplatte (3) elektrisch verbunden sind;
wobei die elektrischen Anschlüsse (17) mit den elektrischen Anschlusselementen (19) elektrisch verbunden sind und wobei eine Anschlussstelle (25), an der die elektrischen Anschlüsse (17) mit den elektrischen Anschlusselementen (19) verbunden sind, verkapselt ist.

2. Elektronikmodul nach Anspruch 1, wobei die elektrischen Anschlüsse (17) mit den elektrischen Anschlusselementen (19) verschweißt sind.

3. Elektronikmodul nach einem der Ansprüche 1 bis 2, wobei das Sockelelement (7) ein an der Leiterplatte (3) oberflächenmontiertes Bauteil ist.

4. Elektronikmodul nach einem der Ansprüche 1 bis 3, wobei das erste Bauelement (5) und das Sockelelement (7) derart ähnliche Baugrößen aufweisen, dass sie mittels eines selben Bestückungsautomaten auf die Leiterplatte (3) bestückt werden können.

5. Elektronikmodul nach einem der Ansprüche 1 bis 4, wobei das zweite Bauelement (9) ein Sensor, ein Stecker oder eine weitere Baugruppe mit Anschlusskontakten ist.

6. Elektronikmodul nach einem der Ansprüche 1 bis 5, wobei die Schutzmasse (11) ein Lack, eine Vergussmasse, eine Moldmasse oder ein Harz, insbesondere aus einem duroplastischen Material, ist.

7. Verfahren zum Fertigen eines Elektronikmoduls (1), aufweisend:
Bereitstellen einer Leiterplatte (3);
Anordnen eines ersten Bauelements (5) an einer Oberfläche der Leiterplatte (3);
Anordnen eines Sockelelements (7), welches eine erste Oberfläche (6) und eine dieser entgegengesetzte zweite Oberfläche (8) aufweist, mit seiner ersten Oberfläche (6) an der Oberfläche der Leiterplatte (3);
Anordnen eines zweiten Bauelements (9) an dem Sockelelement (7);
Einbetten des ersten Bauelements (5) in eine Schutzmasse (11) zum Schutz vor Umwelteinflüssen derart, dass das erste Bauelemente (5) in der Schutzmasse (11) einkapselt ist;
wobei mit dem Einbetten des ersten Bauelements (5) auch das Sockelelement (7) teilweise in die Schutzmasse (11) derart eingebettet wird,
dass seitliche Flanken (10) des Sockelelements (7) von der Schutzmasse (11) bedeckt werden und die zweite Oberfläche (8) des Sockelelements (7) freiliegend aus der Schutzmasse (11) heraus ragt, **dadurch gekennzeichnet, dass** das zweite Bauelement (9) elektrische Anschlüsse (17) aufweist und das Sockelelement (7) elektrische Anschlusselemente (19) aufweist, welche mit elektrisch leitfähigen Strukturen an der Leiterplatte (3) elektrisch verbunden werden;
wobei die elektrischen Anschlüsse (17) mit den elektrischen Anschlusselementen (19) elektrisch verbunden werden und eine Anschlussstelle (25), an der die elektrischen Anschlüsse (17) mit den elektrischen Anschlusselementen (19) verbunden werden, verkapselt wird.

8. Verfahren nach Anspruch 7, wobei das Einbetten mittels eines Dispensvorgangs erfolgt.

9. Verfahren nach Anspruch 7 oder 8, wobei die elektrischen Anschlüsse (17) mit den elektrischen Anschlusselementen (19) verschweißt werden.

10. Verfahren nach einem der Ansprüche 7 bis 9, wobei das Sockelelement (7) und das zweite elektrische Bauelement (9) aneinander irreversibel, insbesondere durch Kleben, Warmverstemmen und/oder Pressverbinden, mechanisch befestigt werden.

## Claims

1. Electronic module (1), comprising:
a circuit board (3);
a first component (5), which is arranged on a surface of the circuit board (3) and fastened thereon;
a base element (7), which has a first surface (6) and a second surface (8) opposite the latter, and which is arranged with its first surface (6) lying on the surface of the circuit board (3) and fastened thereon;
a second component (9), which is fastened on the base element (7) and is electrically connected via the latter to the circuit board (3);
a protective compound (11) for protecting against environmental influences, which is arranged on the surface of the circuit board (3) and encapsulates the first component (5); wherein the base element (7) is partially embedded in the protective compound (11) in such a way that lateral faces (10) of the base element (7) are covered by the protective compound (11) and the second surface (8) of the base element (7) protrudes in an exposed fashion from the protective compound (11),
**characterized in that** the second component (9) has electrical terminals (17), and the base element (7) has electrical terminal elements (19) which are electrically connected to electrically conductive structures on the circuit board (3); wherein the electrical terminals (17) are electrically connected to the electrical terminal elements (19), and wherein a connection position (25), at which the electrical terminals (17) are connected to the electrical terminal elements (19), is encapsulated.

2. Electronic module according to Claim 1, wherein the electrical terminals (17) are welded to the electrical terminal elements (19).

3. Electronic module according to one of Claims 1 to 2, wherein the base element (7) is a part which is surface-mounted on the circuit board (3).

4. Electronic module according to one of Claims 1 to 3, wherein the first component (5) and the base element (7) have similar sizes such that they can be fitted on the circuit board (3) by means of one and the same applicator machine.

5. Electronic module according to one of Claims 1 to 4, wherein the second component (9) is a sensor, a plug or a further module having terminal contacts.

6. Electronic module according to one of Claims 1 to 5, wherein the protective compound (11) is a coating, an encapsulation compound, a moulding compound or a resin, in particular consisting of a thermosetting material.

7. Method for producing an electronic module (1), comprising:
provision of a circuit board (3);
arrangement of a first component (5) on a surface of the circuit board (3);
arrangement of a base element (7), which has a first surface (6) and a second surface (8) opposite the latter, with its first surface (6) on the surface of the circuit board (3);
arrangement of a second component (9) on the base element (7) ;
embedding of the first component (5) into a protective compound (11) for protecting against environmental influences in such a way that the first component (5) is encapsulated in the protective compound (11);
wherein, with the embedding of the first component (5), the base element (7) is also partially embedded into the protective compound (11) in such a way that lateral faces (10) of the base element (7) are covered by the protective compound (11) and the second surface (8) of the base element (7) protrudes in an exposed fashion from the protective compound (11), **characterized in that** the second component (9) has electrical terminals (17), and the base element (7) has electrical terminal elements (19) which are electrically connected to electrically conductive structures on the circuit board (3);
wherein the electrical terminals (17) are electrically connected to the electrical terminal elements (19), and a connection position (25), at which the electrical terminals (17) are connected to the electrical terminal elements (19), is encapsulated.

8. Method according to Claim 7, wherein the embedding is carried out by means of a dispensing process.

9. Method according to Claim 7 or 8, wherein the electrical terminals (17) are welded to the electrical terminal elements (19).

10. Method according to one of Claims 7 to 9, wherein the base element (7) and the second electrical component (9) are mechanically fastened to one another irreversibly, in particular by adhesive bonding, hot caulking and/or compression connection.

## Revendications

1. Module électronique (1) comprenant :
une carte de circuit imprimé (3) ;
un premier composant (5) qui est disposé sur une surface de la carte de circuit imprimé (3) et qui fixé à celle-ci ;
un élément de base (7) qui comporte une première surface (6) et une deuxième surface (8) opposée à celle-ci et qui est disposé avec sa première surface (6) en appui avec la surface de la carte de circuit imprimé (3) et qui est fixé à celle-ci ;
un deuxième composant (9) qui est fixé à l'élément de base (7) et qui est relié électriquement connecté par le biais de celui-ci à la carte de circuit imprimé (3) ;
une substance de protection (11) destinée à la protection contre les influences environnementales, qui est disposée sur la surface de la carte de circuit imprimé (3) et qui encapsule le premier composant (5) ;
l'élément de base (7) étant partiellement enrobé dans la substance de protection (11) de telle manière que des flancs latéraux (10) de l'élément de base (7) soient recouverts par la substance de protection (11) et la deuxième surface (8) de l'élément de base (7) fasse saillie de manière dégagée de la substance de protection (11), **caractérisé en ce que** le deuxième composant (9) comporte des bornes électriques (17) et l'élément de base (7) comporte des éléments de raccordement électrique (19) qui sont reliés électriquement aux structures électriquement conductrices de la carte de circuit imprimé (3) ;
les bornes électriques (17) étant reliées électriquement aux éléments de raccordement électrique (19) et un point de raccordement (25), au niveau duquel les bornes électriques (17) sont reliées aux éléments de raccordement électrique (19), étant encapsulé.

2. Module électronique selon la revendication 1, les bornes électriques (17) étant soudées aux éléments de raccordement électrique (19).

3. Module électronique selon l'une des revendications 1 à 2, l'élément de base (7) étant un composant monté en surface sur la carte de circuit imprimé (3).

4. Module électronique selon l'une des revendications 1 à 3, le premier composant (5) et l'élément de base (7) ayant des dimensions structurelles similaires de sorte qu'ils puissent être assemblés sur la carte de circuit imprimé (3) au moyen du même système d'assemblage automatique.

5. Module électronique selon l'une des revendications 1 à 4, le deuxième composant (9) étant un capteur, un connecteur enfichable ou un autre ensemble à contacts de raccordement.

6. Module électronique selon l'une des revendications 1 à 5, la substance de protection (11) étant une peinture, une substance d'enrobage, une substance de moulage ou une résine, notamment en matière thermodurcissable.

7. Procédé de fabrication d'un module électronique (1), comprenant les étapes suivantes :
fournir une carte de circuit imprimé (3) ;
disposer un premier composant (5) sur une surface de la carte de circuit imprimé (3) ;
disposer un élément de base (7) qui comporte une première surface (6) et une deuxième surface (8) opposée à celle-ci, ladite première surface (6) étant disposée sur la surface de la carte de circuit imprimé (3) ;
disposer un deuxième composant (9) sur l'élément de base (7) ;
enrober le premier composant (5) dans une substance de protection (11) destinée à la protection contre les influences environnementales de telle sorte que le premier composant (5) soit encapsulé dans la substance de protection (11) ;
l'enrobage du premier composant (5) entraînant également l'enrobage partiel de l'élément de base (7) dans la substance de protection (11) de telle manière que les flancs latéraux (10) de l'élément de base (7) soient recouverts par la substance de protection (11) et la deuxième surface (8) de l'élément de base (7) fasse saillie de manière dégagée de la substance de protection (11), **caractérisé en ce que** le deuxième composant (9) comporte des bornes électriques (17) et l'élément de base (7) comporte des éléments de raccordement électrique (19) qui sont reliés électriquement à des structures électriquement conductrices de la carte de circuit imprimé (3) ;
les bornes électriques (17) étant reliées électriquement aux éléments de raccordement électrique (19) et un point de raccordement (25), au niveau duquel les bornes électriques (17) sont reliées aux éléments de raccordement électrique (19), étant encapsulé.

8. Procédé selon la revendication 7, l'enrobage étant effectué au moyen d'un procédé de distribution.

9. Procédé selon la revendication 7 ou 8, les bornes électriques (17) étant soudées aux éléments de raccordement électrique (19).

10. Procédé selon l'une des revendications 7 à 9, l'élément de base (7) et le deuxième composant électrique (9) étant fixés mécaniquement l'un à l'autre de manière irréversible, notamment par collage, matage à chaud et/ou assemblage à la presse.
